(19) Europäisches Patentamt
European Patent Office
Office européen des brevets

(11) Veröffentlichungsnummer: **0 539 327 B1**

(12) **EUROPÄISCHE PATENTSCHRIFT**

(45) Veröffentlichungstag der Patentschrift: **28.06.95**

(51) Int. Cl.$^{6}$: **C08K 5/527**, C08L 63/04

(21) Anmeldenummer: **92810784.6**

(22) Anmeldetag: **13.10.92**

# (54) Mit organischen Phosphorverbindungen stabilisierte Epoxy-Novolake.

(30) Priorität: **22.10.91 CH 3079/91**
**25.10.91 CH 3134/91**

(43) Veröffentlichungstag der Anmeldung:
**28.04.93 Patentblatt 93/17**

(45) Bekanntmachung des Hinweises auf die Patenterteilung:
**28.06.95 Patentblatt 95/26**

(84) Benannte Vertragsstaaten:
**AT BE CH DE FR GB IT LI NL**

(56) Entgegenhaltungen:
**EP-A- 0 412 936**
**EP-A- 0 456 605**
**FR-A- 2 371 455**

(73) Patentinhaber: **CIBA-GEIGY AG**
**Klybeckstrasse 141**
**CH-4002 Basel (CH)**

Patentinhaber: **SHIN-ETSU CHEMICAL CO., LTD.**
**6-1, Ohtemachi 2-chome**
**Chiyoda-ku**
**Tokyo (JP)**

(72) Erfinder: **Shiobara, Toshio**
**10-13, Isobe 3-chome**
**Annaka-shi,**
**Gunma-ken (JP)**
Erfinder: **Tomiyoshi, Kazutoshi**
**800-19, Yawata-machi**
**Takasaki-shi,**
**Gunma-ken (JP)**
Erfinder: **Okada, Tadashi, Dr.**
**Stallenmattstrasse 45**
**CH-4104 Oberwil (CH)**
Erfinder: **Flury, Peter, Dr.**
**Muldenweg**
**CH-4204 Himmelried (CH)**

(74) Vertreter: **Szele, Ivanka et al**
**c/o Ciba-Geigy AG,**
**Patentabteilung,**
**Postfach**
**CH-4002 Basel (CH)**

EP 0 539 327 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft neue Zusammensetzungen enthaltend einen epoxidierten Novolak und mindestens eine spezifische organische Phosphorverbindung als Flammhemmer, sowie die Verwendung dieser Zusammensetzungen in Enkapsulierungssystemen und in Laminierharzen.

Die Flammwidrigkeit von Polymeren kann auf verschiedene Arten verbessert werden, z.B. durch Reduzierung des organischen Polymeranteils bei Zugabe von schwerbrennbaren Füllstoffen, wie z.B. Quarzmehl, Glas oder Wollastonit, ferner durch Zusatz von Flammschutzmitteln, wie beispielsweise Borverbindungen, Metallhydroxide, bromierte Verbindungen, halogenierte Phosphorsäureester oder spezifische organische Phosphor-Verbindungen, wie z.B. in der europäischen Patentanmeldung Nr.0456605 beschrieben.

Bei den Epoxy-Novolaken, die in Enkapsulierungssystemen und in Laminierharzen Anwendung finden und flammgehemmt sein müssen, werden heute als Flammhemmungsmittel meistens Kombinationen von bromierten organischen Verbindungen im Gemisch mit Antimontrioxid eingesetzt, wobei als bromierte organische Verbindung üblicherweise ein bromierter und glycidylisierter Novolak eingesetzt wird.

Seit einiger Zeit sind Bestrebungen im Gange, Ersatzprodukte für Antimontrioxid aus ökologischen und arbeitshygienischen Gründen zu entwickeln, umso mehr als Antimontrioxid bevorzugt in feiner (Staub)form eingesetzt wird, weil es in dieser Form die beste Flammhemmungswirkung zeigt.
Eliminiert man die Antimontrioxidkomponente, so stellt man fest, dass sich die Thermobeständigkeit der Enkapsulierungs- bzw. Umhüllungsmassen wesentlich verschlechtert.

Es wurde nun überraschend gefunden, dass bestimmte Kombinationen aus epoxidierten Novolaken und spezifischen, sterisch gehinderten organischen (Thio)-Phosphaten ohne Verwendung von Antimontrioxid und mit geringem Halogenanteil in den Enkapsulierungs- und Laminiersystemen eine ausgezeichnete Flammhemmung gewährleisten, ohne dass dabei die anderen anwendungstechnischen Eigenschaften, wie thermische Beständigkeit, mechanische Festigkeit, Dielektrizitätskonstanz oder Wasseraufnahme, wesentlich beeinflusst werden.

Die vorliegende Erfindung betrifft demnach Zusammensetzungen enthaltend

a) ein epoxidiertes Novolakharz und

b) 0,1 bis 100 Gewichtsteile, bezogen auf 100 Gew.Teile der Komponente a), mindestens einer Verbindung der Formel I

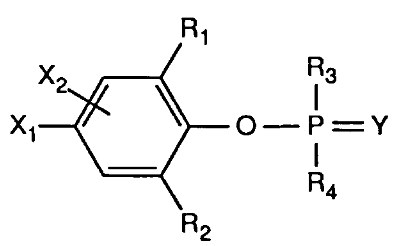

(I),

worin $X_1$ Chlor oder Brom bedeutet,
$X_2$ Chlor, Brom oder Wasserstoff ist, und
Y fur O oder S, und
$R_1$ und $R_2$ unabhängig voneinander $C_1$-$C_4$-Alkyl bedeuten, und
$R_3$ und $R_4$ eine gleich oder verschieden substituierte Gruppe der Formel II

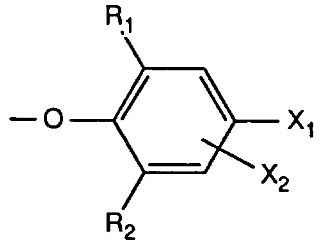

(II),

worin $R_1$, $R_2$, $X_1$ und $X_2$ die oben angegebene Bedeutung haben, oder $R_3$ und $R_4$ zusammen eine

Gruppe der Formel III bilden

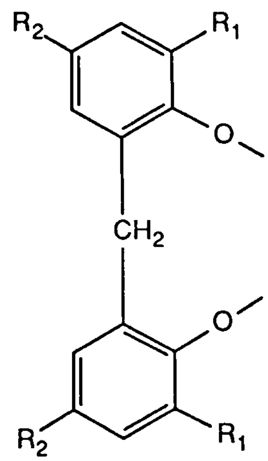

(III),

worin $R_1$ und $R_2$ die oben angegebene Bedeutung haben.

$X_1$ und $X_2$ bedeuten Chlor und vorzugsweise Brom. $X_2$ ist bevorzugt Wasserstoff. Y bedeutet bevorzugt O.

$R_1$ und $R_2$ können als Alkylsubstituenten unabhängig voneinander beispielsweise Methyl, Ethyl, Propyl, Isopropyl, Butyl oder tert.-Butyl sein. $R_1$ bedeutet in den Formeln 1 und II vorzugsweise Methyl oder tert.-Butyl; in der Formel III bedeutet $R_1$ bevorzugt tert.-Butyl. Die bevorzugte Bedeutung von $R_2$ ist Methyl.

In bevorzugten Verbindungen der Formel I bedeuten $X_1$ Brom, $X_2$ Wasserstoff und Y Sauerstoff.

In besonders bevorzugten Verbindungen der Formel I bedeuten $X_1$ Brom, $X_2$ Wasserstoff, Y Sauerstoff, $R_1$ Methyl oder tert.-Butyl, $R_2$ Methyl, und $R_3$ und $R_4$ je eine gleich substitutierte Gruppe der Formel II bedeuten, wobei $X_1$, $X_2$, $R_1$ und $R_2$ die oben angegebene Bedeutung haben.

Weitere bevorzugte Verbindungen weisen die Formel I auf, worin $R_3$ und $R_4$ zusammen eine Gruppe der Formel III bilden, und $X_1$ Brom, $X_2$ Wasserstoff, Y Sauerstoff, $R_1$ und $R_2$ in der Formel I Methyl und $R_1$ in der Formel III tert.-Butyl, und $R_2$ in der Formel III Methyl sind.

Die Verbindungen der Formel I sowie deren Herstellung sind bekannt und z.B. in der oben angegebenen europäischen Patentanmeldung Nr. 0456605 beschrieben.

Als epoxidierte Novolake kommen z.B. epoxidierte Phenol- und Kresol-Novolakharze, die z.B. durch Kondensation von phenolischen Verbindungen mit Aldehyden erhalten werden, in Frage. Durch ihre hohe Funktionalität, in der Regel 2 bis 6 Epoxidgruppen pro Molekül, sind sie in Verbindung mit den üblichen Vernetzungsmitteln bevorzugt bei höheren Temperaturen fähig, ein sehr enges makromolekulares Netzwerk aufzubauen.

Beispiele von phenolischen Verbindungen sind Phenol, Alkylphenole mit bis zu 9 C-Atomen im Alkyl, z.B Kresole, Xylenole, Ethyl-, Propyl- und Butylphenole, ferner Phenylphenole, Resorcin, Pyrocatechol, Hydrochinon, Bisphenol A und Pyrogallol.

Beispiele von Aldehyden sind Formaldehyd, Acetaldehyd, Benzaldehyd und Terephthalsäure-dialdehyd.

Bevorzugt sind Phenol- und insbesondere Kresol-Formaldehyd-Harze, zu deren Herstellung o-, m- oder p-Kresol oder Mischungen dieser Isomeren in beliebigen oder vorbestimmten Verhältnissen eingesetzt werden. Die Herstellung solcher Harze ist bekannt.

Bevorzugt verwendet man 0,5 bis 30 Gewichtsteile und besonders bevorzugt 2 bis 20 Gewichtsteile einer Verbindung der Formel I, bezogen auf 100 Gewichtsteile der Komponente a). Die optimale Menge hängt von der Natur der Komponente a) und der Art der eingesetzten Verbindung der Formel I ab und kann leicht durch einfache Versuche ermittelt werden.

Da die Verbindungen der Formel I im allgemeinen schon bei geringen Zusatzmengen wirksam und zudem halogenarm sind, verursachen sie im Novolak gegenüber anderen bekannten Flammhemmern kaum unerwünschte Effekte.

Die Verbindungen der Formel I können je nach Art des verwendeten epoxidierten Novolakes und der gewünschten Eigenschaften in verschiedener physikalischer Form angewendet werden. So können sie z.B. zum Erzielen einer besseren Dispersion im Novolak zu einer feinteiligen Form vermahlen werden. Gemische verschiedener Verbindungen der Formel I können auch eingesetzt werden.

Die erfindungsgemässen Zusammensetzungen eignen sich zur Herstellung von gehärteten Produkten, z.B. für Enkapsulierungen beziehungsweise Umhüllungen, z.B. von elektronischen Bauteilen, wie von integrierten Schaltungen, oder zur Herstellung von Laminaten, wobei ein Härter für die Komponente a) verwendet wird.

Dabei können auch Gemische von verschiedenen erfindungsgemässen Zusammensetzungen und/oder Härtern verwendet werden.

Als Härter eignen sich an sich beliebige Epoxidharzhärter, wie z.B. Cyanamid, Dicyandiamid, Polycarbonsäuren, Polycarbonsäureanhydride, Polyamine, Polyaminoamide, Addukte aus Aminen und Polyepoxiden, und Polyole.

Geeignete Polycarbonsäuren und ihre Anhydride sind z.B. Phthalsäureanhydrid oder Tetrahydro- und Hexahydrophthalsäureanhydrid, sowie die zu den oben genannten Anhydriden gehörenden Säuren.

Als Beispiele von Polyaminen, die sich als Härtungsmittel eignen, seien aliphatische, cycloaliphatische, aromatische und heterocyclische Polyamine, wie Hexamethylendiamin, Diethylentriamin, m-Xylylendiamin, Bis(4-amino-cyclohexyl)methan, m- und p-Phenylendiamin, Bis(4-aminophenyl)methan, Bis(4-aminophenyl)-sulfon und Anilin-Formaldehydharze, genannt. Geeignete Polyaminoamide sind z.B. solche, die aus aliphatischen Polyaminen und dimerisierten oder trimerisierten ungesättigten Fettsäuren hergestellt sind.

Als Polyolhärter kommen vor allem ein- oder mehrkernige aromatische Polyole, einschliesslich Novolake, in Betracht, wie Resorcin, Hydrochinon, 2,6-Dihydroxytoluol, Pyrogallol, 1,1,3-Tris(hydroxyphenyl)-propan, Bis(4-hydroxyphenyl)methan, 2,2-Bis(4-hydroxyphenyl)propan, Bis(4-hydroxyphenyl)sulfon und 4,4'-Dihydroxybiphenyl, sowie Novolake aus Formaldehyd oder Acetaldehyd und Phenol, Chlorphenol oder Alkylphenolen mit bis zu 9 C-Atomen im Alkylrest, besonders Phenol- und Kresol-Novolake.

Bevorzugte Härter sind Polycarbonsäureanhydride, wie Tetrahydro- und Hexahydrophthalsäureanhydrid, sowie aromatische Polyamine, besonders Bis(4-aminophenyl)methan, Bis(4-aminophenyl)sulfon und m- oder p-Phenylendiamin, sowie ganz besonders Polyolhärter auf Novolakbasis, insbesondere Kresol-Novolake oder Phenol-Novolake.

Die erfindungsgemässen Gemische können noch weitere übliche Zusätze enthalten, z.B. einen Beschleuniger und/oder weitere Zusätze.

Als Beschleuniger können ebenfalls an sich bekannte Verbindungen verwendet werden. Als Beispiele seien genannt: Komplexe von Aminen, besonders tertiären Aminen, wie Monoethylamin mit Bortrifluorid oder Bortrichlorid, tertiäre Amine, wie Benzyldimethylamin, Harnstoffderivate, wie N-4-Chlorphenyl-N',N'-dimethylharnstoff (Monuron), gegebenenfalls substituierte Imidazole, wie Imidazol oder 2-Phenylimidazol, sowie Sulfoniumsalze und tertiäre Phosphine.

Die Härter werden in den üblichen wirksamen, d.h. für die Härtung der erfindungsgemässen Gemische ausreichenden Mengen eingesetzt. Das Verhältnis der Komponente a) und des Härters hängt von der Art der verwendeten Verbindungen, der erforderlichen Härtungsgeschwindigkeit und den im Endprodukt gewünschten Eigenschaften ab und kann vom Fachmann auf dem Gebiet der Epoxidharz-Härtung leicht ermittelt werden. Wenn das Härtungsmittel ein Amin ist, werden zweckmässig 0,75 bis 1,25 Aequivalente Aminwasserstoff pro 1 Epoxidäquivalent eingesetzt. Bei Polycarbonsäure- oder Polycarbonsäureanhydrid-Härtern verwendet man gewöhnlich 0,4 bis 1,1 Aequivalente Carboxyl- oder Anhydridgruppen pro 1 Epoxidäquivalent. Bei der Verwendung von Polyolhärtern als Härtungsmittel setzt man zweckmässig 0,75 bis 1,25 Aequivalente phenolische Hydroxylgruppen pro 1 Epoxidäquivalent ein.

Die Beschleuniger können im allgemeinen in Mengen von 0,1 bis 5 Gewichtsprozent, bezogen auf das Epoxy-Novolakharz (a), verwendet werden.

Gewünschtenfalls kann man den härtbaren Gemischen zur Herabsetzung der Viskosität reaktive Verdünner, wie z.B. Styroloxid, Butylglycidylether, 2,2,4-Trimethylpentylglycidylether, Phenylglycidylether, Kresylglycidylether oder Glycidylester von synthetischen, hochverzweigten, in der Hauptsache tertiären aliphatischen Monocarbonsäuren, zusetzen. Als weitere übliche Zusätze können die erfindungsgemässen Gemische ferner Weichmacher, Streck-, Füll- und Verstärkungsmittel, wie beispielsweise Steinkohlenteer, Bitumen, Textilfasern, Glasfasern, Asbestfasern, Borfasern, Kohlenstoff-Fasern, mineralische Silikate, Glimmer, Quarzmehl, Aluminiumoxidhydrat, Betonite, Kaolin, Kieselsäureaerogel oder Metallpulver, z.B. Aluminiumpulver oder Eisenpulver, ferner Pigmente und Farbstoffe, wie Russ, Oxidfarben und Titandioxid, zusätzliche Flammschutzmittel, Thixotropiemittel, Verlaufmittel ("flow control agents"), wie Silicone, Wachse und Stearate, die zum Teil auch als Formtrennmittel Anwendung finden, Haftvermittler, Antioxidantien und Lichtschutzmittel, ferner Verschäumungsmittel, Fungizide, oder antistatische Mittel enthalten.

Als zusätzliche Flammhemmer, die zusammen mit den erfindungsgemäss verwendeten Verbindungen der Formel I zweckmässig eingesetzt werden können, kommen z.B. phosphorhaltige Salze, wie z.B. Ammoniumpolyphosphate, ferner Aluminiumhydroxid, Wismutoxid, Molybdänoxid oder Gemische dieser Verbindungen mit Zink- und/oder Magnesiumoxid oder -salzen, insbesondere aber nicht-halogenierte

Triphenylphosphate in Betracht. Nicht-halogenierte Triphenylphosphate können z.B. sterisch gehinderte Phenylreste aufweisen, z.B. mit mindestens einer tert.-Butylgruppe aber auch mit mindestens einer Methylgruppe in ortho-Stellung zur phenolischen Hydroxylgruppe.

Die erfindungsgemässen Zusammensetzungen finden Anwendung zur Herstellung von gehärteten Produkten, wie Laminaten, insbesondere jedoch zum Umhüllen elektronischer Bauteile, z.B. elektronischer Schaltungen. Sie können in jeweils dem speziellen Anwendungsgebiet angepasster Formulierung, in ungefülltem oder gefülltem Zustand, z.B. als Pressmassen, Tauchharze, Giessharze, Imprägnierharze, Laminierharze und Matrixharze, verwendet werden.

Die Härtung der erfindungsgemässen Gemische kann auf an sich bekannte Weise einoder zweistufig vorgenommen werden. Die Härtung der erfindungsgemässen Gemische erfolgt im allgemeinen durch Erhitzen auf Temperaturen zwischen 80 und 200 °C, besonders 100 und 180 °C.

Die mit den erfindungsgemäss erhältlichen Polyepoxiden hergestellten gehärteten Produkte zeichnen sich durch gute mechanische, thermische und chemische Eigenschaften aus.

Bei der Herstellung von Laminierharzen, z.B. von Faserverbundsystemen, kann man zweckmässig als Verstärkungsfasern die üblichen bei der Faserverstärkung von Werkstoffen verwendeten Fasern einsetzen. Diese können organische oder anorganische Fasern, Naturfasern oder Synthesefasern, wie Aramid-Fasern, sein und als Faserbündel oder Endlosfasern vorliegen. Beispielsweise verwendet man als Verstärkungsfasern Glas-, Asbest-, Bor-, Kohlenstoff- und Metallfasern, vorzugsweise Kohlenstoff- und Metallfasern. Solche Fasern und Gewebe daraus sind im Handel erhältlich.

Die Erfindung wird durch die folgenden Beispiele näher erläutert:

Beispiele 1 bis 3: Prüfkörper werden aus dem folgenden epoxidierten Kresol-Novolak mit einem Epoxidgehalt von 200 Aeq/kg (EOCN 1020® der Firma Nippon Kayaku Co) unter Zusatz des Flammhemmers A oder B oder einer Kombination des Flammhemmers B im Gemisch mit einem nicht-halogenierten organischen Phosphat, und unter Einsatz der aus nachstehender Tabelle ersichtlichen weiteren Zusatzstoffen hergestellt.

Die Prüfkörper enthalten einen Silizium-Chip mit einer Alumimium-Streifen-Struktur (5 µm Breite, 1 µm Dicke) aufgebracht auf einem thermisch oxidiertem $SiO_2$-Substrat. Dieser Chip wird auf ein Trägermaterial (Leadframe) aus einer Metall-Legierung (Alloy 42) mit Hilfe eines Epoxy-Klebstoffes aufgebracht, und der Kleber wird dann thermisch gehärtet. Danach werden die Anschlusspunkte der Aluminium-Streifen mit dem Trägermaterial über Golddrähte verbunden, und das erhaltene strukturierte Material als Ganzes wird anschliessend mit einem Epoxy-Novolaksystem (siehe nachstehende Tabelle) umhüllt. Formgebungstemperatur: 175 °C während 2 Minuten; Formdruck: 700 NT/cm$^2$. Nachhärtungstemperatur: 180 °C während 4 Stunden.

Nach der Entformung werden die Prüfkörper auf ihre Leitfähigkeit (in Ohm) nach Lagerung bei 200 °C geprüft, wobei eine Leitfähigkeit grösser als 10 Ohm bereits als untauglich bewertet wird.

Aus dem selben epoxidierten Kresol-Novolak werden Prüfstäbe gefertigt (Formgebungstemperatur: 175 °C während 2 Minuten; Formdruck: 700 NT/cm$^2$; Nachhärtungstemperatur: 180 °C während 4 Stunden) und auf ihre Brennbarkeit nach der Norm von Underwriter Laboratories Inc. UL 94,3. Ausgabe (Revision) vom 25 September 1987 (vertikale Brennbarkeitsprüfung) geprüft.

Tabelle (die angegebenen Mengen bedeuten Gewichtsteile):

| Komponenten des Epoxy-Novolacksystems | Beispiele: 1 | 2 | 3 |
|---|---|---|---|
| a) Epoxidiertes Novolak | 393,6 | 393,6 | 393,6 |
| b) Novolak (Härter) | 206,4 | 206,4 | 206,4 |
| A) Verb. gemäss Formel I | 101,4 | | |
| B) Verb. gemäss Formel I | | 48,6 | 32,4 |
| c) nicht-halogeniertes Phosphatderivat | | 48,6 | 48,6 |

| | | | | |
|---|---|---|---|---|
| d) | Silanderivat | 6 | 6 | 6 |
| e) | Wachs | 6 | 6 | 6 |
| f) | Russ | 6 | 6 | 6 |
| g) | Phosphinderivat | 4,8 | 4,8 | 4,8 |
| h) | RD-8 (Füllstoff) | 2400 | 2400 | 2400 |

<u>Bromgehalt</u>, bezogen auf die gesamte Novolakharzmenge (a+b):

| | | |
|---|---|---|
| Beispiele | 1 und 3 | : je 2 Gew.%; |
| Beispiel | 2 | : 3 Gew.%. |

<u>Legende der Tabelle 1</u>:

a) Epoxidiertes Kresol-Novolakharz mit Epoxidgehalt 200 Aeq/kg; [EOCN 1020®; Lieferant: Nippon Kayaku Co];

b) Phenol-Novolakharz TD 2093® [Lieferant Dainippon Ink Co];

c) nicht-halogeniertes organisches Phosphat FY 511® [Ciba-Geigy AG; Struktur gemäss der Formel I, worin $X_1$ und $X_2$ Wasserstoff, Y Sauerstoff, und $R_1$ und $R_2$ Methyl sind, und $R_3$ und $R_4$ zusammen ein Gruppe der Formel III bilden, wobei $R_1$ tert.-Butyl und $R_2$ Methyl sind];

d) 3-Glycidyloxypropyltrimethoxysilan [ KBM 403®; Lieferant Shin-Etsu Chem.];

e) Carnaubaharz;

f) Russ;

g) Triphenylphosphin;

h) Silikatpulver (Kieselsäure) mit einem durchschnittlichen Partikel-Durchmesser von 13 µm [RD-8; Lieferant Tatsumori Co];

A) 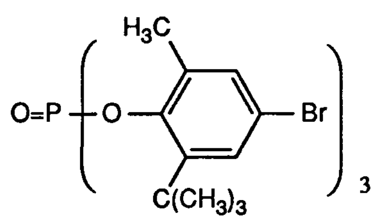

B) 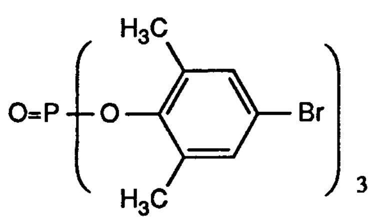

| Prüfungsergebnisse: | | | |
|---|---|---|---|
| Flammhemmung gemäss Beispiel (nach UL 94/2 mm) | 1 V-O | 2 V-O | 3 V-O |
| Leitfähigkeitsfehlerrate nach Temperaturlagerung bei 200 °C | | | |
| 141 Stunden<br>338 Stunden | 0/15<br>0/15 | 0/15<br>0/15 | 0/15<br>0/15 |

Aus dieser Tabelle ist ersichtlich, dass die erfindungsgemässen Zusammensetzungen in der geprüften Anwendung gemäss den oben angegebenen Beispielen 1, 2 und 3 eine ausgezeichnete Flammhemmung (V-O) und nach 141 und 338 Stunden bei 200 °C noch keinen Ausfall in der Leitfähigkeit aufweisen, dies bei Verwendung von stark reduziertem Bromgehalt in den Harzzusammensetzungen (2 %, beziehungsweise 3 %); Vergleichbare Prüfungen ohne Verwendung einer Verbindungen der Formel I jedoch durch Einsatz einer entsprechenden Menge eines bromierten und epoxidierten Novolakharzes im Gemisch mit einem Anteil an $Sb_2 0_3$ weisen dagegen eine deutlich schlechtere Leitfähigkeit auf.

## Patentansprüche

**1.** Zusammensetzungen enthaltend

a) ein epoxidiertes Novolakharz und

b) 0,1 bis 100 Gewichtsteile, bezogen auf 100 Gew.Teile der Komponente a), mindestens einer Verbindung der Formel I

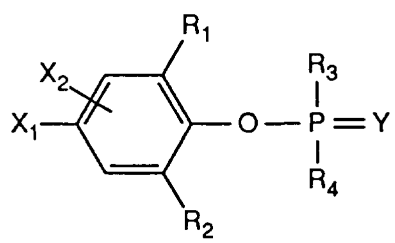

(I),

worin $X_1$ Chlor oder Brom bedeutet,
$X_2$ Chlor, Brom oder Wasserstoff ist, und
Y für O oder S, und
$R_1$ und $R_2$ unabhängig voneinander $C_1$-$C_4$-Alkyl bedeuten, und
$R_3$ und $R_4$ eine gleich oder verschieden substituierte Gruppe der Formel II

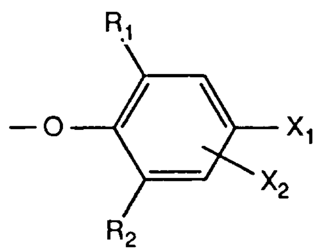

(II),

worin $R_1$, $R_2$, $X_1$ und $X_2$ die oben angegebene Bedeutung haben, sind, oder
$R_3$ und $R_4$ zusammen eine Gruppe der Formel III bilden

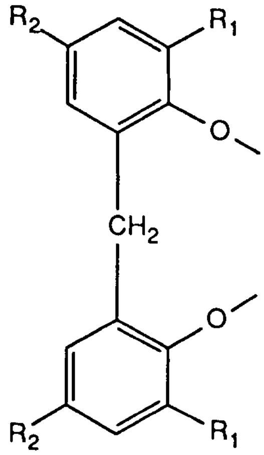

(III),

worin $R_1$ und $R_2$ die oben angegebene Bedeutung haben.

2. Zusammensetzungen gemäss Anspruch 1, wobei $X_1$ Brom, $X_2$ Wasserstoff und Y Sauerstoff bedeuten.

3. Zusammensetzungen gemäss Anspruch 1, wobei $R_1$ und $R_2$ unabhängig voneinander Methyl, Ethyl, Propyl, Isopropyl, Butyl oder tert.-Butyl sind.

4. Zusammensetzungen gemäss Anspruch 1, wobei $R_1$ in den Formeln I und II Methyl oder tert.-Butyl bedeutet.

5. Zusammensetzungen gemäss Anspruch 1, wobei in der Formel I $X_1$ Brom, $X_2$ Wasserstoff, Y Sauerstoff, $R_1$ Methyl oder tert.-Butyl, $R_2$ Methyl, und $R_3$ und $R_4$ je eine gleich substituierte Gruppe der Formel II bedeuten, wobei $X_1$, $X_2$, $R_1$ und $R_2$ die im Anspruch 5 angegebene Bedeutung haben.

6. Zusammensetzungen gemäss Anspruch 1, wobei in der Formel I $R_3$ und $R_4$ zusammen eine Gruppe der Formel III bilden, und $X_1$ Brom, $X_2$ Wasserstoff, Y Sauerstoff, $R_1$ und $R_2$ in der Formel I Methyl und $R_1$ in der Formel III tert.-Butyl, und $R_2$ in der Formel III Methyl sind.

7. Zusammensetzungen gemäss Anspruch 1, wobei 0,5 bis 30 Gewichtsteile einer Verbindung der Formel I eingesetzt werden.

8. Zusammensetzungen gemäss Anspruch 1, wobei als Komponente a) ein epoxidiertes Phenol- oder Kresol-Novolakharz verwendet wird.

9. Zusammensetzungen gemäss Anspruch 1, wobei als Novolakharz einen Kresol-Formaldehyd-Harz verwendet wird.

10. Verwendung der Zusammensetungen gemäss Anspruch 1 zur Herstellung von Laminaten oder in Umhüllungssystemen.

11. Verwendung gemäss Anspruch 11 zur Umhüllung von elektronischen Bauteilen.

**Claims**

1. A composition comprising
   a) an epoxidized novolak, and
   b) 0.1 to 100 parts by weight, based on 100 parts by weight of component a), of at least one compound of formula I

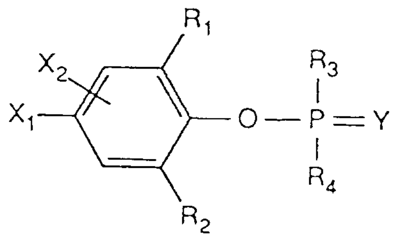

(I),

wherein $X_1$ is chloro or bromo,
$X_2$ is chloro, bromo or hydrogen, and
Y is O or S, and
$R_1$ and $R_2$ are each independently of the other $C_1$-$C_4$alkyl, and
$R_3$ and $R_4$ are a group of formula II

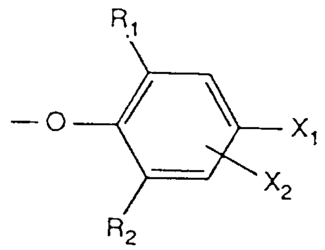

(II),

wherein $R_1$, $R_2$, $X_1$ and $X_2$ are as defined above, which group carries identical or different substituents, or $R_3$ and $R_4$, when taken together, form a group of formula III

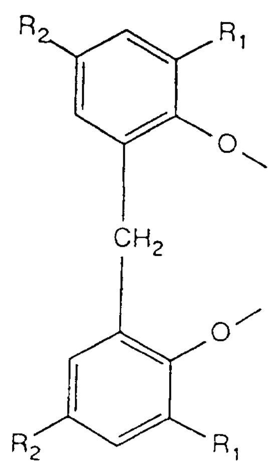

(III),

wherein $R_1$ and $R_2$ are as defined above.

**2.** A composition according to claim 1, wherein $X_1$ is bromo, $X_2$ is hydrogen and Y is oxygen.

**3.** A composition according to claim 1, wherein $R_1$ and $R_2$ are each independently of the other methyl, ethyl, propyl, isopropyl, butyl or tert-butyl.

**4.** A composition according to claim 1, wherein $R_1$ in formulae I and II is methyl or tert-butyl.

**5.** A composition according to claim 1, wherein in formula I $X_1$ is bromo, $X_2$ is hydrogen, Y is oxygen, $R_1$ is methyl or tert-butyl, $R_2$ is methyl, and $R_3$ and $R_4$ are each an identically substituted group of formula II in which $X_1$, $X_2$, $R_1$ and $R_2$ are as defined in claim 5.

6. A composition according to claim 1, wherein in formula I $R_3$ and $R_4$, when taken together, form a group of formula III, and $X_1$ is bromo, $X_2$ is hydrogen, Y is oxygen, $R_1$ and $R_2$ in formula I are methyl, and $R_1$ in formula III is tert-butyl, and $R_2$ in formula III is methyl.

7. A composition according to claim 1, in which 0.5 to 30 parts by weight of a compound of formula I are employed.

8. A composition according to claim 1, wherein as component a) an epoxidized phenol novolak resin or an epoxy cresol novolak resin is used.

9. A composition according to claim 1, wherein the novolak resin used is a cresol-formaldehyde resin.

10. Use of a composition according to claim 1 for producing laminates or in encapsulating systems.

11. Use according to claim 11 for encapsulating electronic components.

**Revendications**

1. Compositions qui comprennent :
   a) une résine novolaque époxydée et
   b) de 0,1 à 100 parties en poids, pour 100 parties du composant a), d'au moins un composé de formule I

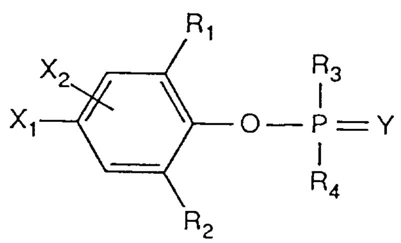

(I),

dans laquelle
$X_1$ représente le chlore ou le brome,
$X_2$ le chlore, le brome ou l'hydrogène,
Y l'oxygène ou le soufre,
$R_1$ et $R_2$, indépendamment l'un de l'autre, un alkyle en $C_1$-$C_4$, et
$R_3$ et $R_4$ sont des groupes de formule II à substituants identiques ou différents

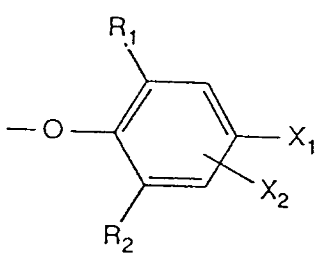

(II),

dans laquelle $R_1$, $R_2$, $X_1$ et $X_2$ ont la signification donnée ci-dessus, ou bien $R_3$ et $R_4$ forment ensemble un groupe de formule III

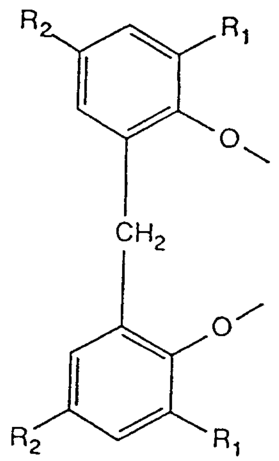

(III),

Dans laquelle $R_1$ et $R_2$ ont la significaion ci-dessus.

**2.** Compositions, selon la revendication 1, dans lesquelles $X_1$ représente le brome, $X_2$ l'hydrogène et Y l'oxygène.

**3.** Compositions, selon la revendication 1, dans lesquelles $R_1$ et $R_2$ sont indépendamment l'un de l'autre un méthyle, un éthyle, un propyle, un isopropyle, un butyle ou un tert-butyle.

**4.** Compositions, selon la revendication 1, dans lesquelles $R_1$, dans les formules I et II, est un méthyle ou un tert-butyle.

**5.** Compositions selon la revendication 1, dans lesquelles, dans la formule I, $X_1$ représente un brome, $X_2$ un hydrogène, Y un oxygène, $R_1$ un méthyle ou un tert-butyle, $R_2$ un méthyle et $R_3$ et $R_4$ sont chacun un groupe de formule II avec des substituants identiques, dans laquelle $X_1$, $X_2$, $R_1$ et $R_2$ ayant la signification donnée dans la revendication 5.

**6.** Compositions selon la revendication 1, dans lesquelles, dans la formule I, $R_3$ et $R_4$ forment ensemble un groupe de formule III, $X_1$ est le brome, $X_2$ l'hydrogène, Y l'oxygène et $R_1$ et $R_2$ le groupe méthyle dans la formule I, et dans la formule III, $R_1$ est le groupe tert-butyle et $R_2$ le groupe méthyle.

**7.** Compositions selon la revendication 1 qui comprennent de 0,5 à 30 parties en poids d'un composé de formule I.

**8.** Compositions selon la revendication 1 dont le composant a) est une résine de novolaque phénolique ou crésolique époxydée.

**9.** Compositions selon la revendication 1 dont la résine de novolaque est une résine crésol-formaldéhyde.

**10.** Utilisation des compositions selon la revendication 1 pour la fabrication de produits stratifiés ou d'enrobage.

**11.** Utilisation selon la revendication 11 pour l'enrobage d'éléments et pièces électroniques.